# EUROPEAN PATENT APPLICATION

(11) **EP 4 703 949 A1**
(43) Date of publication of application: **04.03.2026**
(21) Application number: 24796902.5
(22) Date of filing: 18.04.2024
(51) Int. Cl.: G06F 30/13, G06F 30/20, G06Q 50/08, G06T 19/00

(54) **PERFORMANCE INFORMATION SERVER, IMAGE APPLICATION, INFORMATION ACQUISITION METHOD, INFORMATION PROVISION METHOD, AND INFORMATION ACQUISITION SYSTEM**

(30) Priority: 27.04.2023 JP 2023073508
(71) Applicant: TADANO LTD., Takamatsu-shi, Kagawa 761-0185 (JP)
(72) Inventor: UENO, Shunsuke, Takamatsu-shi, Kagawa 761-0185 (JP)
(74) Representative: MFG Patentanwälte Meyer-Wildhagen Meggle-Freund Gerhard PartG mbB
(86) International application number: PCT/JP2024/015359
(87) International publication number: WO 2024/225149

(57) **Abstract**

There is provided a work information server including: a request acquisition unit that acquires a request including information related to work of assembling a jib to a crane from an image application which operates in a terminal capable of displaying an image of the crane; a storage unit that stores pieces of specification data of the crane and the jib; and a control unit that generates information related to a region image to be used by the crane and the jib in the work based on the information related to the work that is included in the request and the pieces of specification data, and presents a response including the generated information related to the region image to the image application.

## Description

### Technical Field

The present invention relates to a performance information server, an image application, an information acquisition method, an information provision method, and an information acquisition system.

### Background Art

Recently, in the construction industry, applications such as 3D Computer Aided Design (CAD) and building information modeling (BIM) have been used for a building design and a work plan (refer to Patent Literature 1). Such an application generates a 3D image of a building or a working machine and displays the 3D image on a display unit. In particular, the BIM is also used, for example, in a case of creating a work plan using a crane, a bulldozer, and a truck.

### Citation List

### Patent Literature

Patent Literature 1: JP 2006-318112 A

### Summary of the Invention

### Problems to be Solved by the Invention

On the other hand, in an actual construction site, in a case where work is performed by a crane, work of assembling a jib to a crane (hereinafter, this is referred to as "jib assembling work") is required. For this reason, when creating a work plan, an operator of the BIM may need to determine whether or not jib assembling work can be performed.

In the related art, an operator of the BIM determines whether to perform jib assembling work by looking at an image of a crane displayed on a display unit of a terminal on which the BIM is operated and an image of a member disposed around the crane. However, in such a method, there is a possibility that it is not possible to accurately determine whether or not jib assembling work can be performed.

The present invention has been made in view of the above circumstances, and an object of the present invention is to provide a technique capable of accurately determining whether to perform jib assembling work.

### Solutions to Problems

One aspect of a performance information server according to the present invention includes:
a request acquisition unit that acquires a request including information related to work of assembling a jib to a crane from an image application which operates in a terminal capable of displaying an image of the crane;
a storage unit that stores pieces of specification data of the crane and the jib; and
a control unit that generates information related to a region image to be used by the crane and the jib in the work based on the information related to the work that is included in the request and the pieces of specification data, and presents a response including the generated information related to the region image to the image application.

One aspect of an image application according to the present invention is
an image application that operates in a terminal capable of displaying an image of a crane on a display unit,
in a case where the image application is executed by the terminal, the image application causing the terminal to:
   generate a request including information related to work of assembling a jib to the crane;
   transmit the request to a performance information server connected to the terminal via a network;
   acquire, from the performance information server, a response including information related to a region image to be used by the crane and the jib in the work of assembling the jib to the crane; and
   display, on the display unit, the region image together with the image of the crane based on the information related to the region image.

One aspect of an information provision method according to the present invention is
an information provision method that is executed in a performance information server connected to a terminal on which an image application operates, the image application being an application capable of displaying an image of a crane on a display unit, the information provision method including:
acquiring a request including information related to work of assembling a jib to the crane from the image application which operates in a terminal capable of displaying an image of the crane;
generating information related to a region image to be used by the crane and the jib in the work of assembling the jib to the crane based on pieces of specification data of the crane and the jib that are stored in advance, and the information related to the work that is included in the request; and
presenting a response including the generated information related to the region image to the image application.

One aspect of an information acquisition method according to the present invention is
an information acquisition method that is executed in a terminal on which an image application operates, the image application being an application capable of displaying an image of a crane on a display unit, the information acquisition method including:
generating a request including information related to work of assembling a jib to the crane;
transmitting the request to a performance information server connected to the terminal via a network;
acquiring, from the performance information server, a response including information related to a region image to be used by the crane and the jib in the work of assembling the jib to the crane; and
displaying, on the display unit, the region image together with the image of the crane based on the information related to the region image.

One aspect of an information acquisition system according to the present invention is
an information acquisition system including:
an image application that operates in a terminal capable of displaying an image of a crane on a display unit; and
a performance information server that is connected to the terminal, in which
the image application causes the terminal to
   transmit a request including information related to work of assembling a jib to the crane to the performance information server connected to the terminal via a network, and
the performance information server
   generates information related to a region image to be used by the crane and the jib in the work of assembling the jib to the crane based on pieces of specification data of the crane and the jib that are stored in advance and information related to the work that is included in the request acquired from the image application, and
   presents a response including the generated information related to the region image to the image application.

### Effects of the Invention

According to the present invention, it is possible to provide a technique capable of accurately determining whether to perform jib assembling work.

### Brief Description of Drawings

[Fig. 1] Fig. 1 is a diagram illustrating a configuration of a BIM support system according to an embodiment 1.
[Fig. 2] Fig. 2 is a functional block diagram of the BIM support system according to the embodiment 1.
[Fig. 3] Fig. 3 is a block diagram illustrating an example of a hardware configuration of a client terminal.
[Fig. 4] Fig. 4 is a diagram illustrating a flow of data between a working machine and a server.
[Fig. 5] Fig. 5 is a block diagram illustrating an example of a hardware configuration of a server according to the embodiment 1.
[Fig. 6] Fig. 6 is a flowchart illustrating an example of an operation (region image acquisition operation) of the BIM support system.
[Fig. 7A] Fig. 7A is a diagram illustrating an example of an image displayed on a display unit in the region image acquisition operation.
[Fig. 7B] Fig. 7B is a diagram illustrating an example of an image displayed on a display unit in the region image acquisition operation.
[Fig. 8A] Fig. 8A is a diagram illustrating a region image when viewed from a direction indicated by an arrow A₁ in Fig. 7B.
[Fig. 8B] Fig. 8B is a diagram illustrating a region image when viewed from above in Fig. 7B.
[Fig. 8C] Fig. 8C is a diagram illustrating a region image when viewed from diagonally above in Fig. 7B.
[Fig. 9A] Fig. 9A is a diagram illustrating a region image when a second jib is assembled to a crane.
[Fig. 9B] Fig. 9B is a diagram illustrating a region image when a second jib is assembled to a crane.
[Fig. 10A] Fig. 10A is a diagram illustrating a region image when a second jib is assembled to a crane by a vertical assembling method.
[Fig. 10B] Fig. 10B is a diagram illustrating a region image when a second jib is assembled to a crane by a vertical assembling method.

### Description of Embodiments

Hereinafter, embodiments of the present invention will be described in detail with reference to the drawings. Hereinafter, the present embodiment will be described with appropriate reference to the drawings. The same elements throughout the specification are denoted by the same reference numerals unless otherwise specified. The matters to be described below with reference to the accompanying drawings are intended to explain exemplary embodiments, and are not intended to represent only the embodiments. For example, in a case where an order of operations is indicated in the embodiment, the order of the operations may be appropriately changed within a range in which no inconsistency occurs as a whole operation.

### [Embodiment]

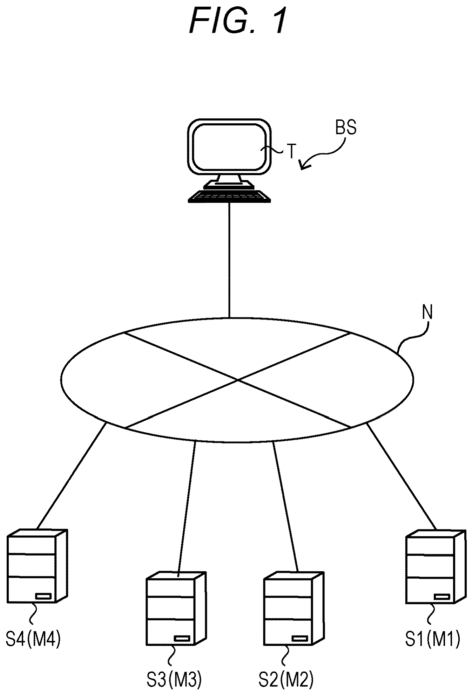

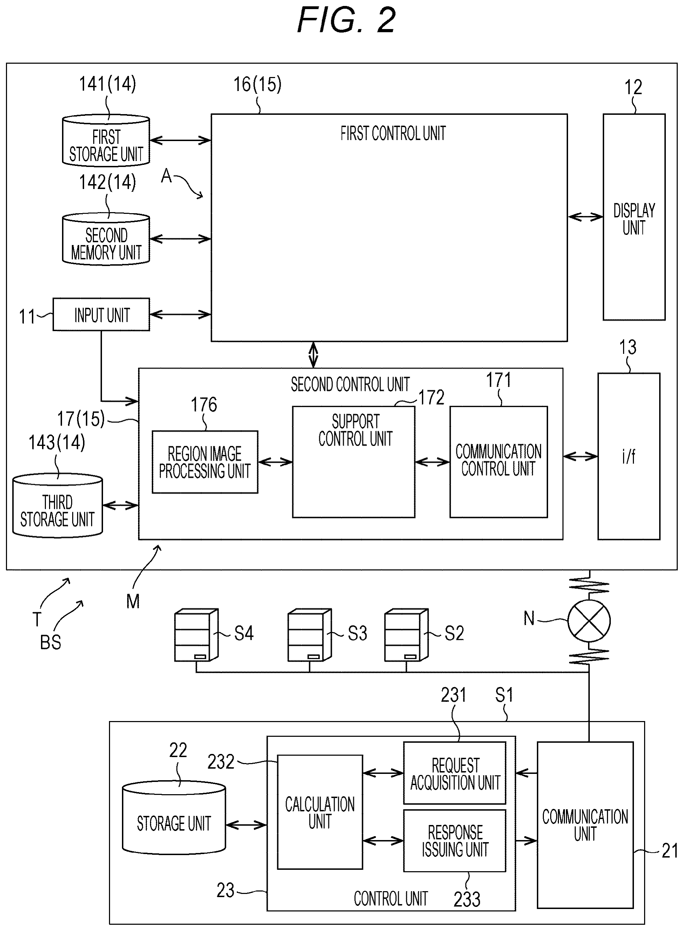

Fig. 1 is a diagram illustrating a configuration of a BIM support system BS according to an embodiment. Fig. 2 is a block diagram illustrating a configuration of the BIM support system BS according to the embodiment.

Hereinafter, a system configuration of the BIM support system BS according to the present embodiment will be described with reference to Fig. 1 and Fig. 2. The BIM support system BS corresponds to an example of an information acquisition system.

The BIM support system BS includes, as a hardware configuration, a client terminal T and a plurality of servers S1 to S4. Each of the servers S1 to S4 corresponds to an example of a performance information server.

Note that the BIM support system BS according to the present embodiment is a client-server type BIM support system in which the client terminal T and the servers S1 to S4 are connected to each other via a network N. The number of the client terminals and the servers in the BIM support system BS is not limited to the illustrated case.

A BIM application A is installed in the client terminal T. The BIM application A corresponds to an example of an image application. An image application support module M (hereinafter, simply "support module M") is added into the BIM application A. Note that an application obtained by combining the BIM application A and the support module M can also be regarded as an image application.

The BIM application A is software specialized for the BIM. The BIM application A may be various types of software for the BIM capable of planning, designing, constructing, and/or managing a structure (a building, infrastructure, or the like).

Note that the image application according to the present invention is not limited to software specialized for the BIM, and may be, for example, construction information modeling (CIM) or 2D-CAD or 3D-CAD for building design. Further, the image application may be a virtual reality simulator (VR simulator) that performs simulation of a working machine such as a crane in a virtual space. Note that the CIM may be regarded as being included in the BIM.

The support module M acquires, from the servers S1 to S4, information related to a region image indicating a region to be used by a crane and a jib in the work of assembling the jib to the crane displayed on a display unit 12, by using a request-response communication protocol (for example, the HTTPS protocol).

In the following description, an image of the crane displayed on the display unit 12 may be simply referred to as a "crane image". A posture of the crane displayed on the display unit 12 may be simply referred to as a "crane posture". A posture condition defining the posture of the crane may be simply referred to as a "posture condition of the crane".

In addition, the support module M operates in cooperation with the BIM application A that generates an image of a working machine (for example, a crane) to be displayed on the display unit 12. The support module M acquires, from the servers S1 to S4, various types of information related to the working machine displayed on the display unit 12, by using a request-response communication protocol (for example, the HTTPS protocol). Then, the support module M reflects the information acquired from the servers S1 to S4, on the display of the display unit 12.

Specifically, focusing on processing of the support module M, the support module M transmits a request (hereinafter, may be simply referred to as a "region image request") for acquiring information related to the region image, to one specified server (hereinafter, may be referred to as a "specified server") among the servers S1 to S4. The region image is an image indicating a region to be used by the crane and the jib in the work of assembling the jib to the crane.

The support module M may specify the server that transmits the region image request by including, in the region image request, server specifying information for specifying the server corresponding to the image of the crane. The server specifying information is, for example, a uniform resource identifier (URI) of the server.

The region image request includes information (hereinafter, may be referred to as "information related to jib assembling work") related to work of assembling the jib to the crane. The work of assembling the jib to the crane may be referred to as jib assembling work.

The information related to the jib assembling work includes model information, posture information, jib information, work type information, and work stage information. The model information is information indicating a model of the crane displayed on the display unit 12. Specifically, the model information is information indicating a model of the crane that is displayed on the display unit 12 and is a target of the jib assembling work.

The posture information is information indicating a posture of the crane displayed on the display unit 12. In other words, the posture information is information indicating a posture that can be taken by the crane displayed on the display unit 12 in the jib assembling work. Specifically, the posture information includes at least one of a relief angle of a boom, a length of a boom, or a pivoting angle of a boom. Further, the posture information may include information related to an outrigger (specifically, an extension width of an outrigger).

The jib information is information related to the jib (hereinafter, may be referred to as a "target jib") that is a target of the jib assembling work. Specifically, the jib information is information for specifying a type (for example, an identification number) of the target jib.

The work type information is information related to a type of the jib assembling work. Specifically, the jib assembling work includes a so-called "vertical assembling method" and a so-called "flat assembling method".

Although a detailed description is omitted, the vertical assembling method is a method of assembling the jib to the crane in a state where a boom is raised. On the other hand, the flat assembling method is a method of assembling the jib to the crane in a state where a boom is at a lowered position. Note that, in any method, work of assembling a first jib element to an end of a boom is performed in a state where the boom is at a lowered position.

The work type information may be regarded as information indicating whether the jib assembling work is the "vertical assembling method" or the "flat assembling method". Note that the type of the jib assembling work is not limited to the "vertical assembling method" and the "flat assembling method". Further, the name of the jib assembling work is not limited to the "vertical assembling method" and the "flat assembling method".

The work stage information is information related to a work stage of the jib assembling work. The work stage information may be regarded as information indicating a work stage to be performed next in the jib assembling work.

The jib assembling work is divided into a plurality of stages. The jib includes a plurality of jib elements. In the jib assembling work, the plurality of jibs are sequentially assembled to the crane.

In a case where the number of jib elements is three, work of assembling a first jib to the boom is first-stage work in the jib assembling work. Further, work of assembling a second jib to the boom is second-stage work in the jib assembling work. Then, work of assembling a third jib to the boom is third-stage work in the jib assembling work.

The support module M acquires the information related to the region image from the specified server by transmitting the above-described request to the specified server (for example, the server S1). Then, the support module M reflects, on the display of the display unit 12, the information related to the region image that is acquired from the specified server.

On the other hand, focusing on the processing of the servers S1 to S4, each of the servers S1 to S4 acquires the region image request from the support module M. Based on the region image request acquired from the support module M, the servers S1 to S4 acquire information (hereinafter, simply referred to as "information related to the region image") related to the region image to be used by the crane and the jib in the work of assembling the jib to the crane displayed on the display unit 12. Then, the servers S1 to S4 present a response including the information related to the region image, to the support module M that receives the region image request.

The servers S1 to S4 store pieces of specification data of the crane and the jib in advance in order to acquire information related to the region image.

The servers S1 to S4 generate information related to the region image based on information related to the work that is included in a boundary image request and the pieces of specification data of the crane and the jib that are stored.

In a case where the information related to the work includes the model information, the posture information, the jib information, the work type information, and the work stage information described above, the servers S1 to S4 generate the information related to the region image based on the model information, the posture information, the jib information, the work type information, and the work stage information, which are acquired from the support module M, and the pieces of specification data of the crane and the jib that are stored.

Then, the servers S1 to S4 present a response including the generated information related to the region image, to the support module M (that is, the client terminal T).

As described above, an operator (hereinafter, the operator is simply referred to as an "operator".) of the BIM application A can confirm, on the BIM application A, a region to be used by the crane and the jib in the jib assembling work. As a result, it is possible to perform a detailed construction plan including whether or not the jib assembling work can be performed.

The functions of the BIM support system BS have been briefly described above. In the following description, a configuration of the BIM support system BS will be described.

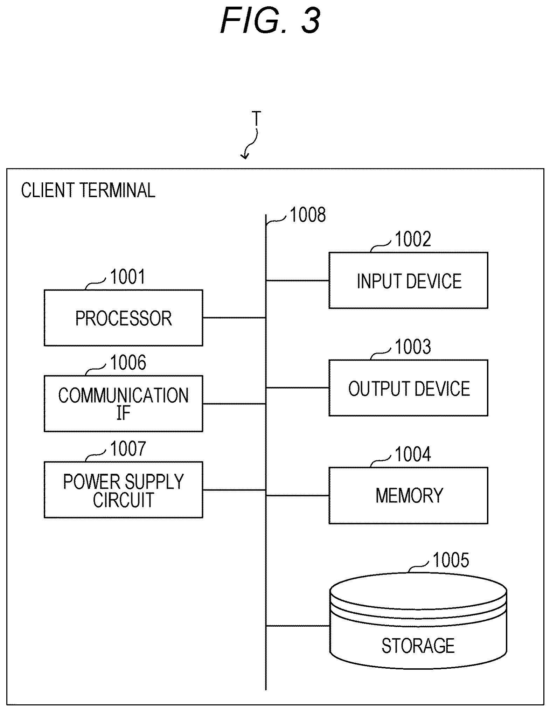

Next, a configuration example of the client terminal T will be described. Fig. 2 is a functional block diagram illustrating an example of a configuration of the BIM support system BS. Fig. 3 is a block diagram illustrating an example of a hardware configuration of the client terminal T. The client terminal T corresponds to an example of a terminal in which the BIM application is incorporated.

The client terminal T includes an input unit 11, a display unit 12, a communication unit 13, a storage unit 14, a control unit 15, and the like.

The input unit 11 receives an input of information and the like input from the operator. The input information by the operator is received by the input unit 11 and is transmitted to the control unit 15. An example of the information received by the input unit 11 will be described below.

The input unit 11 receives an input of a region image request. In a case where the operator requests the information related to the region image from the servers S1 to S4, the operator inputs a region image request to the input unit 11.

The input unit 11 receives an instruction for displaying an image of the building on the display unit 12. Hereinafter, the image of the building is simply referred to as a "building image". In addition, the instruction to display the building image on the display unit 12 is simply referred to as a "display instruction of the building image". In a case where it is desired to display a building image on the display unit 12, the operator inputs a display instruction of the building image to the input unit 11.

The input unit 11 receives an instruction to display a working machine image on the display unit 12. Hereinafter, the instruction to display the working machine image on the display unit 12 is simply referred to as a "display instruction of the working machine image". In particular, the instruction to display the crane image on the display unit 12 as the working machine image is simply referred to as a "display instruction of the crane image".

The display instruction of the working machine image includes information for specifying the model of the working machine (for example, a crane) to be displayed on the display unit 12. Hereinafter, the information for specifying the model of the working machine is simply referred to as "model information".

In addition, the display instruction of the working machine image may include information related to the arrangement of the working machine image. The information related to the arrangement of the working machine image includes, for example, coordinates and/or directions (azimuths).

The model information includes at least one of a working machine ID (a form, a specification number, and/or a serial number), a manufacturer name, and the like.

The input unit 11 receives an operation of an image displayed on the display unit 12. Hereinafter, the operation of the image displayed on the display unit 12 may be simply referred to as an "image operation".

The image operation includes an operation on a building image and/or a working machine image displayed on the display unit 12. Hereinafter, the building image and/or the working machine image displayed on the display unit 12 may be simply referred to as a "display image". In addition, the building image in the display image is also simply referred to as a "building display image". In addition, the working machine image in the display image is also simply referred to as a "working machine display image". In addition, the working machine image is a crane image, the crane image in the display image is also simply referred to as a "crane display image".

Examples of the image operation include at least one of an operation of changing a posture of the building display image, an operation of changing a size (an enlargement operation or a reduction operation) of the building display image, an operation of changing an arrangement of the building display image, and the like. Further, examples of the image operation include at least one of an operation of changing a posture of the working machine display image, an operation of changing a size (an enlargement operation or a reduction operation) of the working machine display image, an operation of changing an arrangement of the working machine display image, and the like.

The operator performs image operation by inputting a numerical value on a setting screen displayed on the display unit 12. In addition, the operator may perform an image operation by dragging the building display image or the working machine display image.

The operator changes the posture of the working machine display image by changing a posture condition (a specific example will be described later) of the working machine display image on the setting screen (not illustrated) displayed on the display unit 12. Alternatively, the operator may change the posture of the working machine display image by dragging the working machine display image.

The display unit 12 displays information and the like. The information displayed on the display unit 12 may be information stored in the storage unit 14 or information generated by the control unit 15.

Note that the input unit 11 and the display unit 12 may be configured by individual devices, or may be integrated into a device that can input and output (display) information in parallel, such as a touch panel display.

The communication unit 13 performs communication with the servers S1 to S4 via the network N. For this purpose, the communication unit 13 includes an information transmission unit and an information reception unit (not illustrated). The communication with the servers S1 to S4 is controlled by, for example, the control unit 15.

Further, the communication unit 13 transmits a request to be described later to the servers S1 to S4, and receives a response to the request from the servers S1 to S4. The communication unit 13 transmits the acquired response to the control unit 15 (specifically, a support control unit 172 of a second control unit 17).

The storage unit 14 includes a first storage unit 141, a second storage unit 142, a third storage unit 143, and the like. Note that the first storage unit 141, the second storage unit 142, and the third storage unit 143 are configured by one piece of hardware (main storage device). On the other hand, the first storage unit 141, the second storage unit 142, and the third storage unit 143 may be configured by a plurality of pieces of hardware.

The first storage unit 141 is a building image database, and stores information related to the building image. The first storage unit 141 stores information related to a three-dimensional image of a constituent member of the building. Hereinafter, a three-dimensional image of a constituent member of the building is simply referred to as a "building image". Examples of the constituent member of the building include at least one of a column, a window, a pipe, a door, a floor, a ceiling, a wall, and the like.

Further, in addition to the building image, the first storage unit 141 may store, for example, information related to an image of a component of a work site such as a building site or a construction site. Hereinafter, the image of the component of the work site is simply referred to as a "work site component image". The work site component image may include, for example, an image of at least one of a road (a sidewalk, a roadway), a tree, an electric wire, a utility pole, a car, or a person.

The second storage unit 142 is a working machine image database, and stores information related to the working machine image. For example, the second storage unit 142 stores information related to a three-dimensional image of the working machine and/or the constituent member of the working machine. Hereinafter, the two-dimensional image or the three-dimensional image of the constituent member of the working machine is simply referred to as a "working machine image".

Examples of the working machine image include, for example, a working machine image of at least one of a crane, a bulldozer, a hydraulic excavator, a concrete pump vehicle, a high-place work vehicle, a dump truck, a trailer, or a lifter. The working machine image may include a three-dimensional image of a constituent member of each working machine.

In a case where the working machine is a crane, examples of the crane include mobile cranes (rough-terrain cranes, all-terrain cranes, crawler cranes) and tower cranes. Examples of the constituent member of the crane include at least one of a boom, a jib, an outrigger, a vehicle, a hook, or a mast.

The second storage unit 142 may store attribute information associated with each working machine image together with the working machine image.

The attribute information of the working machine image includes the model information of the working machine in the working machine image and/or the posture information of the working machine image. The attribute information of the working machine image may include information related to the constituent member of the working machine. Hereinafter, the information related to the constituent member of the working machine is simply referred to as "constituent member information".

The posture information includes at least one of a relief angle of a boom, a length of a boom, or a pivoting angle of a boom. Further, the posture information may include information related to an outrigger (specifically, an extension width of an outrigger).

The constituent member information includes information related to a type of the constituent member of the working machine. The constituent member of the working machine includes, for example, a boom, a jib, a hook, and a wire. Hereinafter, the information related to the type of the constituent member of the working machine is simply referred to as "type information of the constituent member".

The third storage unit 143 stores information for specifying a server that transmits a request. The information for specifying the server is also referred to as server specifying information. The server specifying information is stored in the third storage unit 143 in association with the working machine image.

The third storage unit 143 stores the server specifying information in a format in which the server corresponding to the working machine image can be specified from the model information included in the attribute information of the working machine image.

Specifically, the third storage unit 143 stores an address table in which the model information included in the attribute information of each of the plurality of working machine images is associated with the server (server specifying information) corresponding to each model information.

The control unit 15 controls the overall operation of the client terminal T by controlling the operation of each of the elements 11 to 14 described above. Focusing on the function of the BIM support system BS, the control unit 15 includes a first control unit 16, a second control unit 17, and the like.

The first control unit 16 implements the function of the BIM application A. The first control unit 16 corresponds to an example of an operation control unit of an image application that controls an action of the working machine image displayed on the display unit 12.

The first control unit 16 acquires the information related to the display instruction of the building image from the input unit 11. Then, the first control unit 16 acquires, from the storage unit 14, information related to the building image specified by the information related to the display instruction of the building image. The first control unit 16 transmits the acquired information related to the building image to the display unit 12.

The first control unit 16 acquires, from the input unit 11, the information related to the display instruction of the working machine image. Then, the first control unit 16 acquires, from the storage unit 14, the information related to the working machine image which is specified by the model information included in the acquired display instruction of the working machine image. The first control unit 16 transmits the acquired information related to the working machine image to the display unit 12.

The first control unit 16 acquires information related to an image operation from the input unit 11. The first control unit 16 reflects the acquired information related to the image operation on the image displayed on the display unit 12.

Specifically, the first control unit 16 reflects the acquired information related to the image operation on the image displayed on the display unit 12, by reflecting the acquired information related to the image operation (for example, a coordinate, a dimension, and/or a posture condition) on the display image (for example, the working machine display image).

The second control unit 17 includes a communication control unit 171, a support control unit 172, a region image processing unit 176, and the like. The second control unit 17 implements the function of the support module M.

The communication control unit 171 controls communication between the client terminal T and the servers S1 to S4 via the communication unit 13.

In a case where a region image request is acquired from the input unit 11, the support control unit 172 acquires, from the first control unit 16, information required for acquiring the information related to the region image from the servers S1 to S4. The information acquired by the support control unit 172 is included in parameters for a boundary image request.

Specifically, in a case where a region image request is acquired from the input unit 11, the support control unit 172 acquires information related to the jib assembling work from the first control unit 16.

As described above, the information related to the jib assembling work includes model information, posture information, jib information, work type information, and work stage information.

The support control unit 172 acquires, from the third storage unit 143, the server specifying information for specifying a server corresponding to the model information, based on the model information acquired from the first control unit 16.

Then, the support control unit 172 generates a request including the acquired server specifying information, the acquired region image request, and the acquired information related to the jib assembling work. Note that the information related to the jib assembling work is included in parameters for the request.

The request is, for example, in a form of a request message using the HTTPS protocol. An HTTP method used in the request is, for example, a GET method.

The support control unit 172 analyzes the response acquired from the communication control unit 171, and reflects the calculation results of the servers S1 to S4 that are included in the response, on the display of the display unit 12. The support control unit 172 transmits the calculation results of the servers S1 to S4 that are included in the response to the first control unit 16, and reflects the calculation results on the image to be displayed on the display unit 12 or the image displayed on the display unit 12.

The support control unit 172 transmits the information related to the region image that is included in the response to the region image processing unit 176.

The support control unit 172 transmits the region image acquired from the region image processing unit 176 to the first control unit 16, and reflects the region image on the display of the display unit 12. Note that the region image is an image obtained by reflecting the calculation results (that is, the information related to the region image) of the servers S1 to S4 that are included in the response. The region image may be generated by the servers S1 to S4.

The region image processing unit 176 generates a region image based on the information related to the region image that is acquired from the support control unit 172. Then, the region image processing unit 176 transmits the generated region image to the support control unit 172.

Note that the region image is an image indicating a region to be used by the crane and the jib when the crane displayed on the display unit 12 performs jib assembling. More specifically, the region image is an image indicating a region to be used by the crane and the member assembled to the crane when the crane displayed on the display unit 12 performs jib assembling. The region image may be a two-dimensional image or a three-dimensional image.

Note that the BIM application A and the support module M which are incorporated in the client terminal T as described above may be incorporated in a cloud server (not illustrated) and may be executed. The cloud server is connected to the servers S1 to S4 via the network N.

In addition, the cloud server is connected to a client terminal (not illustrated) in which a viewer is incorporated via the network N. The viewer is an application that displays an image generated by the BIM application A that is executed by the cloud server.

The operator operates the image generated by the BIM application A via the viewer of the client terminal. Such a system corresponds to an example of a cloud-type BIM support system. In the cloud-type BIM support system, the cloud server corresponds to an example of a terminal in which an image generation application is incorporated.

As illustrated in Fig. 3, the client terminal T is a desktop computer (a personal computer, workstation, or the like), a laptop computer (a personal computer, workstation, or the like), a tablet terminal, a mobile device such as a smartphone, or the like.

Focusing on a hardware configuration, the client terminal T includes a processor 1001, an input device 1002, an output device 1003, a memory 1004, a storage 1005, and the like that are included in a general desktop computer or a general laptop computer.

In addition, the client terminal T includes a communication interface (IF) 1006 and a power supply circuit 1007. These elements 1001 to 1007 may be connected to each other via, for example, a bus 1008.

The processor 1001 controls an operation of the client terminal T. The processor 1001 is an example of a circuit or a device that has a computation function. As the processor 1001, for example, at least one of a central processing unit (CPU), a micro processing unit (MPU), or a graphics processing unit (GPU) may be used.

The input device 1002 may include the input unit 11 illustrated in Fig. 2. The input device 1002 may include at least one of devices used for inputting information to the client terminal T, for example, a keyboard, a touch panel, and a mouse. The information may be input to the processor 1001 via the input device 1002.

The output device 1003 may include the display unit 12 illustrated in Fig. 2. Specifically, the output device 1003 may include a display or a monitor corresponding to the display unit 12. The display may be a touch-panel-type display. It may be understood that the touch-panel-type display corresponds to both the input device 1002 and the output device 1003.

The memory 1004 stores, for example, a program to be executed by the processor 1001 and data or information to be processed according to the execution of the program. The memory 1004 includes a random access memory (RAM) and a read only memory (ROM). The RAM may be used as a work memory of the processor 1001. The "program" is referred to as "software" or "application".

The storage 1005 stores a program to be executed by the processor 1001 and data or information to be processed according to the execution of the program. The storage 1005 stores pieces of information related to the BIM support system BS, such as the information related to the building image, the information related to the working machine image, and the server specifying information described above.

The storage 1005 includes a semiconductor drive device such as a hard disk drive (HDD) or a solid state drive (SSD). In addition to or instead of the semiconductor drive device, a non-volatile memory such as a flash memory may be included in the storage 1005. The memory 1004 and the storage 1005 correspond to the storage unit 14 in Fig. 2.

The program includes a program (hereinafter, referred to as a "BIM program") that implements the BIM application A and the support module M as described above. All or a part of program codes included in the BIM program may be stored in the memory 1004 and/or the storage 1005, or may be incorporated into a part of an operating system (OS).

The program and/or the data may be provided in a form of being recorded in a recording medium that can be read by the processor 1001. Examples of the recording medium include a flexible disk, a CD-ROM, a CD-R, a CD-RW, an MO, a DVD, a Blu-ray disk, and a portable hard disk. In addition, a semiconductor memory such as a Universal Serial Bus (USB) memory is also an example of the recording medium.

Further, the program and/or the information may be provided (downloaded) from an application server (not illustrated) to the client terminal T via the network N. The program and/or the information may be provided to the client terminal T via the communication IF 1006, and may be stored in the memory 1004 and/or the storage 1005. Further, the program and/or the data may be provided to the client terminal T via the input device 1002, and may be stored in the memory 1004 and/or the storage 1005.

The communication IF 1006 corresponds to the communication unit 13 in Fig. 2, and is an interface that performs communication with the network N. The communication IF 1006 may include a wireless interface that performs wireless communication. Further, the communication IF 1006 may include a wired interface that performs wired communication.

In a case where the processor 1001 reads and executes the BIM program stored in the storage unit 14, the client terminal T functions as an example of a display processing device that implements the functions of the BIM application A and the support module M as described above.

In a case where the processor 1001 executes the BIM program, the functions of the control unit 15 (specifically, the first control unit 16 and the second control unit 17) illustrated in Fig. 2 are implemented.

The power supply circuit 1007 supplies power for operating each of the elements 1001 to 1006 illustrated in Fig. 3 to each of the elements 1001 to 1006.

The BIM support system BS illustrated in Fig. 1 includes, for example, a plurality of servers S1 to S4. Fig. 1 illustrates four servers S1 to S4 as a non-limiting example. The number of servers may be one or more and three or less, or may be five or more.

The servers S1 to S4 are provided, for example, for each working machine manufacturer. The server S1 is, for example, a server corresponding to a working machine manufacturer M1. Further, the servers S2 to S4 are servers that respectively correspond to working machine manufacturers M2 to M4. Hereinafter, the server S1 among the servers S1 to S4 will be described. Note that, since the configurations of the servers S2 to S4 are similar to the configuration of the server S1, a description of the configurations will be omitted.

The server S1 includes a communication unit 21, a storage unit 22, a control unit 23, and the like.

The communication unit 21 performs communication with the client terminal T via the network N. Therefore, the communication unit 21 includes a transmission unit and a reception unit for information (not illustrated), and the like. The communication with the client terminal T is controlled by the control unit 23. Note that the communication unit 21 performs communication with the servers S2 to S4 via the network N.

In the case of the present embodiment, the server S1 is connected to the client terminal T via the Internet. The server S1 and the client terminal T perform communication using a TCP/IP protocol such as the HTTPS protocol. Note that the communication protocol between the server S1 and the client terminal T is not limited to the HTTPS protocol and may be various communication protocols having a so-called request-response type.

The communication unit 21 transmits the request received from the client terminal T to the control unit 23. Further, the communication unit 21 transmits the response acquired from the control unit 23 to the client terminal T.

The storage unit 22 stores a calculation expression (not illustrated) used in calculation performed by a calculation unit 232. The calculation expression is used for calculating the region image requested by the request from the client terminal T.

The information stored in the storage unit 22 includes specification data of the crane and specification data of the jib. The storage unit 22 stores the specification data of the crane in association with the model information of the crane. That is, the control unit 23 can acquire specification data of the crane that corresponds to the model information of the crane from the storage unit 22 based on the model information of the crane. The specification data of the crane includes information such as a shape, an arrangement, and a dimension related to the configuration of the crane.

In addition, the storage unit 22 stores the specification data of the jib in association with the jib information indicating a type of the jib. That is, the control unit 23 can acquire the specification data of the jib corresponding to the jib information, from the storage unit 22, based on the jib information. The specification data of the jib includes information such as a shape, an arrangement, and a dimension related to the configuration of the jib.

Note that the specification data of the crane and the specification data of the jib are not limited to the above example.

The control unit 23 includes a request acquisition unit 231, a calculation unit 232, a response issuing unit 233, and the like.

The request acquisition unit 231 analyzes the request acquired from the communication unit 21. In the present embodiment, the request is in a form of an HTTP message using the HTTPS protocol. An HTTP method used in the request is a GET method.

Specifically, the request acquisition unit 231 extracts the region image request and the parameter from the request. The parameter is a parameter that corresponds to the region image request, and includes information related to the jib assembling work. As described above, the information related to the jib assembling work includes model information, posture information, jib information, work type information, and work stage information.

The request acquisition unit 231 transmits the information extracted from the request to the calculation unit 232. Note that the processing of the request acquisition unit 231 may be performed by the calculation unit 232.

The calculation unit 232 calculates information related to the region image based on the information acquired from the request acquisition unit 231 and the information acquired from the storage unit 22.

The calculation unit 232 acquires information required for calculating the information related to the region image from the storage unit 22 based on the information related to the jib assembling work that is included in the request.

Then, the calculation unit 232 generates information related to the region image based on the model information, the posture information, the jib information, the work type information, the work stage information, the specification data of the crane, and the specification data of the jib, which are included in the information related to the jib assembling work.

Specifically, the calculation unit 232 specifies a crane corresponding to the model information based on the model information included in the information related to the jib assembling work. The crane specified here may be referred to as a target crane. The calculation unit 232 acquires the specification data of the target crane from the storage unit 22 based on the model information.

In addition, the calculation unit 232 specifies the jib to be used in the jib assembling work based on the jib information included in the information related to the jib assembling work. The jib specified here may be referred to as a target jib. The calculation unit 232 acquires the specification data of the target jib from the storage unit 22 based on the jib information.

In addition, the calculation unit 232 specifies a posture of the target crane based on the posture information included in the information related to the jib assembling work and the specification data of the target crane. The posture of the crane specified here may be referred to as a target posture.

In addition, the calculation unit 232 specifies a method of the jib assembling work based on the work type information included in the information related to the jib assembling work. The method of the jib assembling work specified here may be referred to as a target method.

In addition, the calculation unit 232 specifies a stage of the jib assembling work based on the work stage information included in the information related to the jib assembling work. The stage of the jib assembling work specified here may be referred to as a target stage.

Then, the calculation unit 232 calculates information related to the region image of the target crane. At this time, the posture of the target crane is the target posture specified by the calculation unit 232. In addition, the jib assembled to the target crane is the target jib specified by the calculation unit 232. In addition, the method of the jib assembling work is the target method (for example, a vertical assembling method or a flat assembling method) specified by the calculation unit 232. Further, the stage of the jib assembling work that is to be performed is the target stage specified by the calculation unit 232.

Then, the calculation unit 232 transmits the calculation result to the response issuing unit 233.

The response issuing unit 233 generates a response including the calculation result (specifically, the information related to the region image) acquired from the calculation unit 232. The response issuing unit 233 transmits the generated response to the communication unit 21.

The response is, for example, in a form of a response message using the HTTPS protocol. The calculation result is described in a message body of the response. Then, the response issuing unit 233 transmits the response to the client terminal T via the communication unit 21.

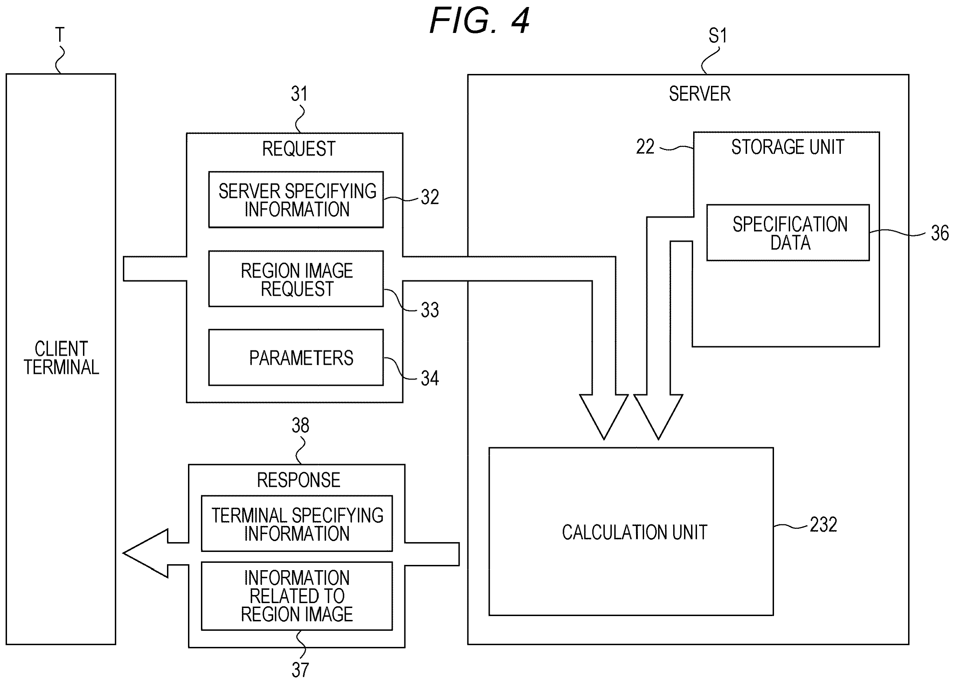

Here, a flow of data between the client terminal T and the server S1 will be described with reference to Fig. 4. Fig. 4 is a diagram schematically illustrating a flow of data between the client terminal T and the server S1.

As illustrated in Fig. 4, first, the client terminal T transmits a request 31 to the server S1. The request 31 includes server specifying information 32 for specifying the server S1, a region image request 33, and a parameter 34.

The parameter 34 includes information related to the jib assembling work. Specifically, the parameter 34 includes model information, posture information, jib information, work type information, and work stage information. Note that the parameter 34 may include at least information required for calculating information related to the region image in the server S1.

The server S1 calculates information related to the region image based on the parameter 34 included in the request 31 acquired from the client terminal T and the specification data 36 acquired from the storage unit 22 of the server S1. The specification data 36 includes the specification data of the crane and the specification data of the jib. Note that the server S1 uses a calculation expression when calculating the information related to the region image. The server S1 stores such a calculation expression.

Then, the server S1 transmits a response 38 including the calculation result (the information 37 related to the region image) to the client terminal T. The response 38 includes terminal specifying information for specifying the client terminal T together with the information 37 related to the region image.

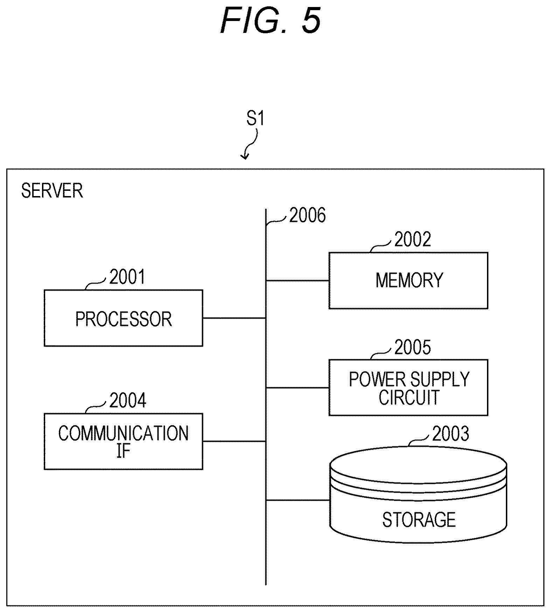

Next, a hardware configuration of the server S1 will be described. As illustrated in Fig. 5, focusing on a hardware configuration, the server S1 includes a processor 2001, a memory 2002, a storage 2003, and the like.

In addition, the server S1 includes a communication IF 2004, a power supply circuit 2005, and the like. Further, the server S1 may include an input device (not illustrated), an output device (not illustrated), and the like. These elements 2001 to 2005 are connected to each other by, for example, a bus 2006.

The configuration of each of the elements 2001 to 2005 is substantially similar to the configuration of each of the elements 1001 to 1007 (refer to Fig. 3) of the client terminal T described above. Therefore, the description of the elements 2001 to 2005 may appropriately refer to the description of the elements 1001 to 1007. In addition, the functional configuration and the hardware configuration of each of the servers S2 to S4 may be equivalent to the functional configuration and the hardware configuration of the server S1.

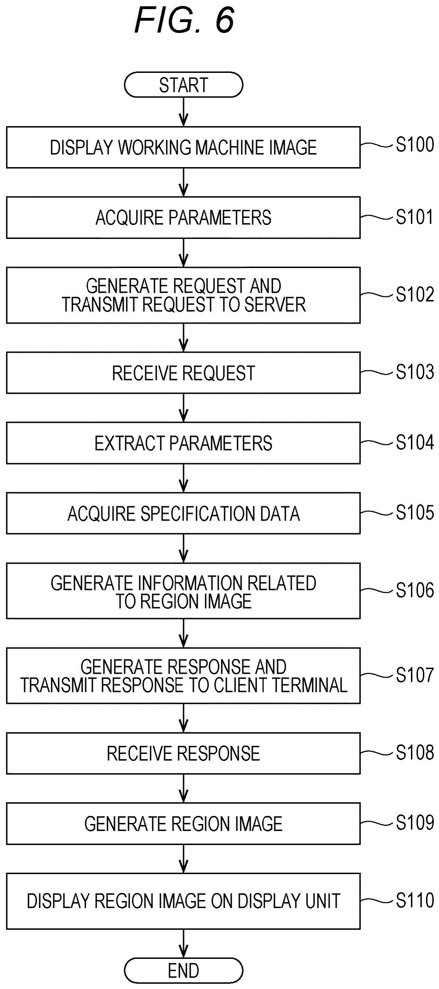

Hereinafter, an example of an operation of the BIM support system BS will be described. This operation is an operation for acquiring, from the servers S1 to S4, a region to be used by the crane and the jib when the crane (that is, the crane image) displayed on the display unit 12 of the client terminal T performs the jib assembling work. Such an operation may be referred to as a region image acquisition operation. Hereinafter, the region image acquisition operation will be described with reference to a flowchart illustrated in Fig. 6. Fig. 6 is a flowchart of the region image acquisition operation.

### (Region Image acquisition Operation)

In the region image acquisition operation, after determining the posture of the crane (that is, the target crane) displayed on the display unit 12, the operator requests the region image from one server (that is, the specified server) specified from the servers S1 to S4. That is, the operator inputs a region image request via the input unit 11.

Note that the region image request may not be input by the operator. That is, the region image request may be automatically generated by the control unit 15 of the client terminal T. Here, the specified server is referred to as a server S1. The server S1 is a server corresponding to the target crane displayed on the display unit 12.

The operator can recognize the region to be used by the target crane and the jib when the target crane performs the jib assembling work from the information related to the region image that is acquired from the server S1. As a result, the operator can determine whether or not the target crane can perform the jib assembling work.

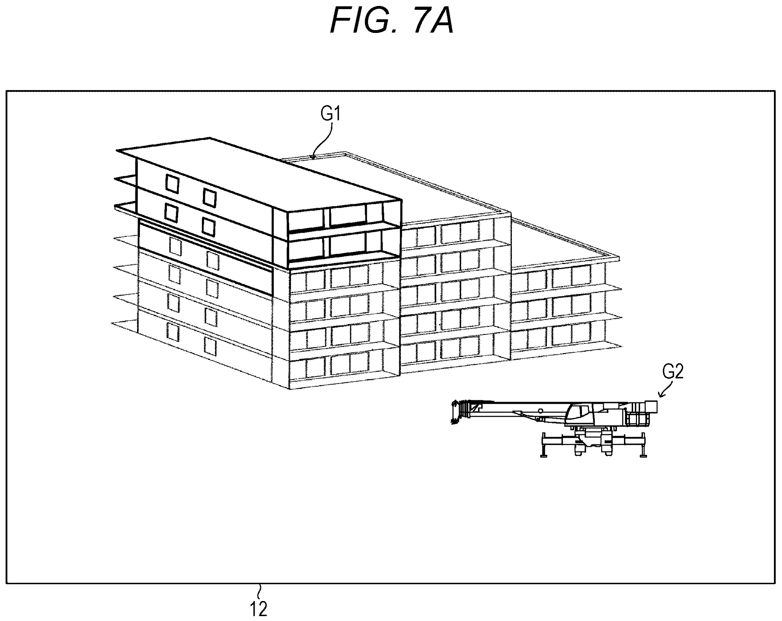

First, in step S100 of Fig. 6, only the building image G1 illustrated in Fig. 7A is displayed on the display unit 12. That is, in step S100, the crane image G2 illustrated in Fig. 7A is not displayed on the display unit 12. The building image G1 may be an image created by the operator using the BIM application A or an image displayed by reading information stored in the storage unit 14.

In step S100, the operator inputs a display instruction of the working machine image via the input unit 11 in order to display the crane image G2 on the display unit 12.

In a case where the input unit 11 receives the display instruction of the working machine image in step S100, the first control unit 16 causes the display unit 12 to display the crane image G2 of the crane (that is, the target crane) specified by the model information designated by the display instruction of the crane image.

In step S100, the first control unit 16 acquires the crane image from the second storage unit 142. Specifically, the first control unit 16 acquires, from the second storage unit 142, the crane image corresponding to the model information designated by the display instruction of the crane image. The posture of the crane image acquired from the second storage unit 142 is a basic posture of the crane image.

Further, in step S100, the operator determines a posture condition of the crane image to be displayed on the display unit 12. Note that, although not illustrated, the crane image having the basic posture is displayed on the display unit 12 before the operator determines the posture condition of the crane image. The operator determines the posture condition of the crane image while viewing the crane image having the basic posture that is displayed on the display unit 12.

In step S100, the posture condition of the crane image that is determined by the operator includes a posture condition related to the boom (specifically, a relief angle of the boom, a length of the boom, and a pivoting angle of the boom). Further, in step S100, the posture condition of the crane image that is determined by the operator may include a posture condition related to an outrigger (specifically, an extension width of an outrigger).

In a case where the posture condition of the crane image is determined in step S100, the first control unit 16 reflects the determined posture condition on the crane image having the basic posture that is displayed on the display unit 12. Then, the crane image G2 as illustrated in Fig. 7A is displayed on the display unit 12.

Next, in step S101, the operator performs an operation for obtaining a region image related to the crane image G2 for which the posture condition is determined in step S100. For example, the operator inputs a region image request via an input screen that is displayed as a pop-up on the display unit 12.

Note that the operation of the operator for obtaining a region image related to the crane image G2 is ended in step S101. The subsequent processing is automatically performed between the client terminal T and the servers S1 to S4. That is, in the region image acquisition operation, in a case where the operator inputs a region image request via the BIM application A, the region image is automatically displayed on the display unit 12.

Further, in a case where the input unit 11 receives the region image request in step S101, the support control unit 172 of the second control unit 17 acquires parameters (specifically, information related to the jib assembling work) corresponding to the acquired region image request from the first control unit 16.

In step S101, the parameters acquired by the support control unit 172 from the first control unit 16 are at least parameters required for the calculation of the region image in the servers S1 to S4. Specifically, in step S101, the support control unit 172 acquires, from the first control unit 16, the model information, the posture information, the jib information, the work type information, and the work stage information which are described above.

Note that, in the region image acquisition operation, the model information is information related to the model of the crane displayed on the display unit 12. The model information may be information that is input from the operator via the input unit 11.

Further, in the region image acquisition operation, the posture information is the posture condition of the crane displayed on the display unit 12, the posture condition being determined in step S100. The posture information may be information that is input from the operator via the input unit 11.

Further, in the region image acquisition operation, the jib information is information for specifying a type (for example, the identification number) of the jib to be used in the jib assembling work. The jib information may be information that is input from the operator via the input unit 11.

Further, in the region image acquisition operation, the work type information is information for specifying a type (method) of the jib assembling work. The work type information may be information that is input from the operator via the input unit 11. In a case where the region image request is requested via the input unit 11 in step S101, the operator may input the work type information.

Further, in the region image acquisition operation, the work stage information is information for specifying information related to the work stage of the jib assembling work. The work stage information may be information that is input from the operator via the input unit 11 in step S101. Alternatively, the work stage information may be information that is acquired by the first control unit 16 based on a state of the crane displayed on the display unit 12 and a state of the jib assembled to the crane (in other words, the number of jib elements).

In step S102, the support control unit 172 of the second control unit 17 acquires, from the third storage unit 143, server specifying information (for example, a URI of the server) for specifying a server corresponding to the crane image (that is, the crane image G2 of Fig. 7A) specified by the acquired model information.

Next, the support control unit 172 of the second control unit 17 generates a request including the acquired server specifying information, the region image request, and the parameter. Then, the second control unit 17 (specifically, the support control unit 172) transmits the generated request to the communication control unit 171. The request is transmitted to the server (for example, the server S1) specified by the server specifying information via the communication unit 13.

Note that the request generated in step S102 is in a form of a request message using the HTTPS protocol. Such a request includes a URI, a region image request, and a parameter in order from the head.

In the request, the URI is server specifying information that is acquired by the support control unit 172 from the third storage unit 143 in step S102. Further, in the request, the region image request is a region image request that is input from the operator in step S102. Furthermore, in the request, the parameter is a parameter that is acquired by the support control unit 172 in step S102.

Hereinafter, processing of the server S1 in a case where the request is received from the client terminal T will be described.

In step S103, the communication unit 21 receives the request. Then, the communication unit 21 transmits the request to the request acquisition unit 231.

In step S104, the request acquisition unit 231 extracts parameters from the acquired request. Then, the request acquisition unit 231 transmits the extracted information to the calculation unit 232.

In step S105, the calculation unit 232 acquires, from the storage unit 22, specification data related to the crane that is specified by the model information included in the parameters acquired from the request acquisition unit 231.

Further, in step S105, the calculation unit 232 acquires, from the storage unit 22, specification data related to the jib that is specified by the jib information included in the parameters acquired from the request acquisition unit 231.

In step S106, the calculation unit 232 generates information related to the region image based on the parameter acquired from the request acquisition unit 231 in step S104 and the pieces of specification data acquired from the storage unit 22 in step S105.

In other words, in step S106, the calculation unit 232 generates information related to the region image based on the model information, the posture information, the jib information, the work type information, the work stage information, the specification data related to the crane, and the specification data related to the jib. Then, the calculation unit 232 transmits the generated information related to the region image to the response issuing unit 233.

In step S107, the response issuing unit 233 generates a response including the information related to the region image that is acquired from the calculation unit 232. Then, the response issuing unit 233 transmits the generated response to the client terminal T via the communication unit 21.

The above-described processing is processing of the server S1 in a case where the request is received from the client terminal T. Next, processing of the client terminal T (support module M) in a case where the response is received from the server S1 will be described.

In step S108, the communication unit 13 receives a response from the server S1. Then, the communication unit 13 transmits the received response to the second control unit 17 (specifically, the support control unit 172). The support control unit 172 extracts information related to the region image from the response. Then, the support control unit 172 transmits the information related to the region image to the region image processing unit 176.

In step S109, the region image processing unit 176 generates a region image based on the information related to the region image that is acquired from the support control unit 172. Then, the region image processing unit 176 transmits the generated region image to the support control unit 172.

In step S110, the support control unit 172 reflects the region image acquired from the region image processing unit 176 on the display of the display unit 12.

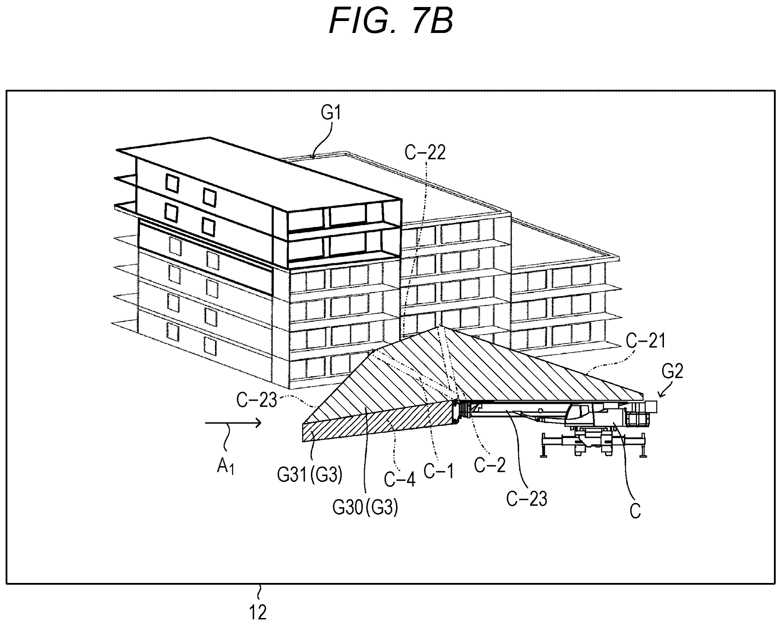

For example, the support control unit 172 causes the display unit 12 to display the region image G3 illustrated in Fig. 7B. In Fig. 7B, the region image G3 is a hatched image. The hatching given to the region image G3 in Fig. 7B is given for convenience of description, and thus the hatching may be omitted.

The region image G3 includes a region image G30 indicating a region surrounded by tension links C-21, C-22, and C-23 stretched between masts C-1 and C-2 of the crane C, and a region image G31 indicating a region surrounded by the outer shape of the jib (specifically, the first jib element). The region image G30 is a region that is coarsely hatched in the region image G3. The region image G31 is a region that is finely hatched in the region image G3.

Note that the crane C corresponding to the crane image G2 illustrated in Fig. 7B includes a pair of masts C-1 and C-2 and tension links C-21, C-22, and C-23. The base end portions of the pair of masts C-1 and C-2 are connected to a distal end portion of the boom C-3.

The tension links C-21, C-22, and C-23 are stretched from a rear end portion of the crane C to the jib C-4 via the distal end portions of the pair of masts C-1 and C-2.

The base end portion of the tension link C-21 is connected to the rear end portion of the crane C. The distal end portion of the tension link C-21 is connected to the base end portion of the tension link C-22. The distal end portion of the tension link C-22 is connected to the base end portion of the tension link C-23.

The distal end portion of the tension link C-23 is connected to the jib C-4. The pair of masts C-1 and C-2 and the tension links C-21, C-22, and C-23 are for maintaining an upright state of the jib C-4.

From the viewpoint of improving visibility, the region image G3 does not include a region surrounded by the outer shape of the crane body. However, the region image G3 may include a region surrounded by the outer shape of the crane body. In this case, it is preferable to display the region surrounded by the outer shape of the crane body in a display mode for allowing the operator to visually recognize the region in an easy way.

The region image G3 illustrated in Fig. 7B is an image indicating a region to be used by the crane and the jib in a case where the crane image G2 illustrated in Fig. 7A is in a state illustrated in Fig. 7A and the jib assembling work is performed by the flat assembling method. Therefore, the work type information included in the request is information indicating the "flat assembling method".

In addition, the region image G3 illustrated in Fig. 7B is a region image when the first jib element is assembled to the crane in the jib assembling work. Therefore, the work stage information included in the request is information indicating "first stage". Therefore, the region image G3 illustrated in Fig. 7B may be regarded as an image indicating a region surrounded by the outer shape of the mast (not illustrated) of the crane and the outer shape of the first jib element (also referred to as a first jib element).

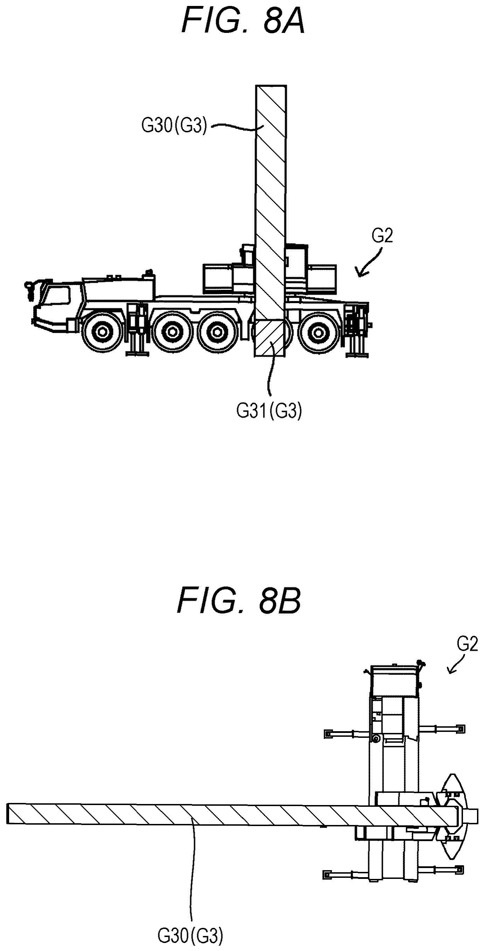

The region image G3 is displayed on the display unit 12 as a three-dimensional image. Fig. 8A to Fig. 8C are diagrams for explaining that the region image G3 is a three-dimensional image.

Fig. 8A is a diagram illustrating the region image G3 when viewed from a direction indicated by an arrow A₁ in Fig. 7B. By viewing the display of Fig. 8A, the operator can determine whether or not the region image G3 and the building image G1 (refer to Fig. 7A) arranged around the crane image G2 interfere with each other in a horizontal direction.

Fig. 8B is a diagram illustrating the region image G3 when viewed from above in Fig. 7B. By viewing the display of Fig. 8B, the operator can determine whether or not the region image G3 and the building image G1 (refer to Fig. 7A) arranged around the crane image G2 interfere with each other in a vertical direction and a horizontal direction (left and right directions in Fig. 8B).

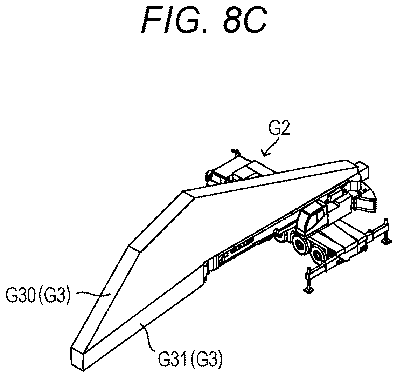

Fig. 8C is a diagram illustrating the region image G3 when viewed from diagonally above in Fig. 7B. By viewing the display of Fig. 8C, the operator can determine whether or not the region image G3 and the building image G1 (refer to Fig. 7A) arranged around the crane image G2 interfere with each other in a vertical direction and a horizontal direction. Note that, in Fig. 8C, the hatching indicating the region image G3 is omitted.

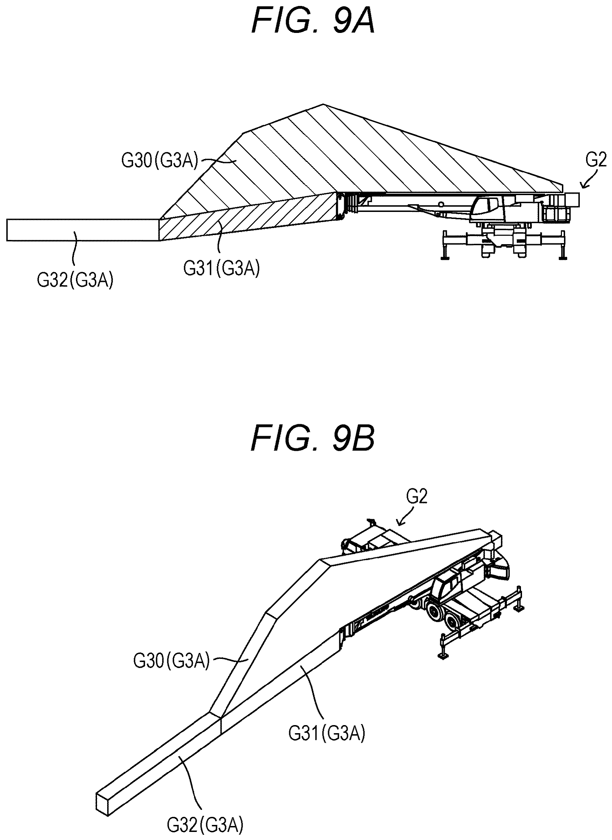

Note that the region image G3A illustrated in Fig. 9A is a region image when the second jib element is assembled to the crane in the jib assembling work. In the region image G3A illustrated in Fig. 9A, a region image G32 corresponding to the second jib element is added to the region image G3 illustrated in Fig. 7B.

The region image G3A illustrated in Fig. 9A is an image indicating a region to be used by the crane and the jib in a case where the crane image G2 illustrated in Fig. 7A is in a state illustrated in Fig. 7A and a second stage of the jib assembling work is performed by the flat assembling method.

In other words, the region image G3A illustrated in Fig. 9A is a region image when the second jib element is assembled to the crane in the jib assembling work using the flat assembling method. Therefore, the work type information included in the request is information indicating the "flat assembling method". Further, the work stage information included in the request is information indicating "second stage".

The region image G3A illustrated in Fig. 9A may be regarded as an image indicating a region surrounded by the outer shape of the mast (not illustrated) of the crane, the outer shape of the first jib element (also referred to as a first jib element), and the second jib element (second jib element). The work stage of the jib assembling work is determined according to the number of jib elements. The region image G3A may be a three-dimensional image as illustrated in Fig. 9B.

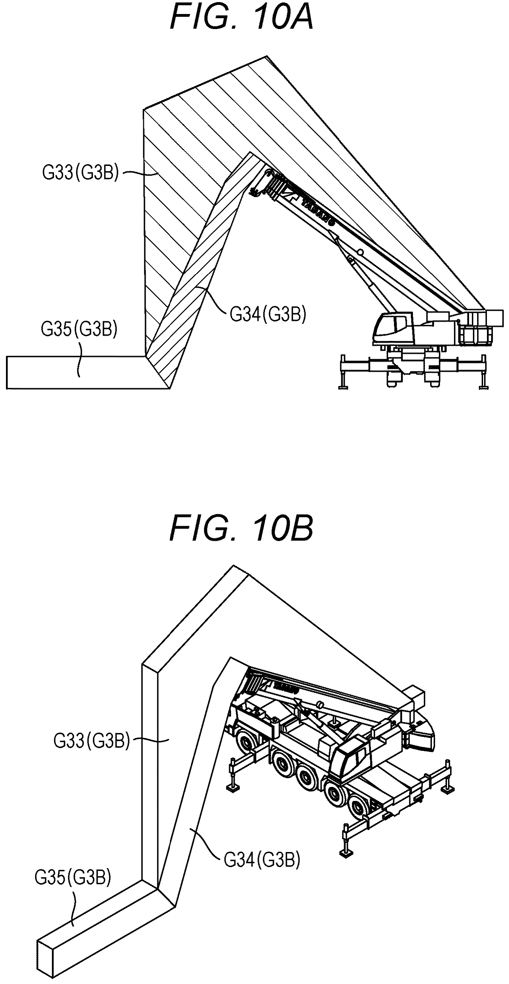

Further, the region image G3B illustrated in Fig. 10A is an image indicating a region to be used by the crane and the jib in a case where the jib assembling work is performed by the vertical assembling method. Therefore, the work type information included in the request is information indicating the "vertical assembling method".

Further, the region image G3B illustrated in Fig. 10A is a region image when the second jib element is assembled to the crane in the jib assembling work. Thus, the work stage information included in the request is information indicating "second stage". Therefore, the region image G3B illustrated in Fig. 10A may be regarded as an image indicating a region surrounded by the outer shape of the mast (not illustrated) of the crane, the outer shape of the first jib element (also referred to as a first jib element), and the outer shape of the second jib element (also referred to as a second jib element).

The region image G3B includes a region image G33 indicating the outer shape of the mast (not illustrated) of the crane, a region image G34 indicating a region surrounded by the outer shape of the first jib element, and a region image G35 indicating a region surrounded by the outer shape of the second jib element. Note that, in the case of the vertical assembling method, similarly to the flat assembling method, the work of assembling the first jib element to the crane is performed in a state where the boom is lowered. Therefore, the region image related to the first-stage work in the vertical assembling method is substantially similar to the region image G3 illustrated in Fig. 7B to Fig. 8C.

### (Functions and Effects of Present Embodiment)

According to the present embodiment as described above, the operator can accurately determine whether to perform the jib assembling work, for example, by viewing the region image G3 illustrated in Fig. 7B to Fig. 8C. As a result, the operator can perform more detailed construction planning work while considering the jib assembling work.

In addition, the operator can determine whether to perform the jib assembling work in the work planning work. Therefore, it is possible to efficiently determine whether to perform the jib assembling work. In a case where the operator determines that the jib assembling work cannot be performed, the operator performs changing of the posture of the crane, changing of the installation place of the crane, and/or changing of the model of the crane, and performs recalculation. Thereby, the operator can efficiently determine the optimum work state.

### (Supplementary Note of Operation Example)

Note that, in the region image acquisition operation described above, the server S1 may acquire information related to a procedure of the jib assembling work. In this case, the server S1 may generate a response including the acquired information related to the procedure of the jib assembling work. Then, the server S1 may transmit the generated response to the client terminal T.

The information related to the procedure of the jib assembling work may be, for example, information related to a procedure of all steps of the jib assembling work. Further, the information related to the procedure of the jib assembling work may be, for example, information related to a procedure of a step to be executed next in the jib assembling work. The server S1 may specify a step to be executed next based on the work stage information included in the request. Further, the information related to the procedure of the jib assembling work may include, for example, information related to the posture of the crane in a step to be executed next. The client terminal T displays the information related to the procedure of the jib assembling work that is presented from the server S1 on the display unit 12. The operator views the information related to the procedure of the jib assembling work that is displayed on the display unit 12, and executes the jib assembling work.

Further, in the operation example described above, the operator requests a region image for each work stage of the jib assembling work. Here, the operator can request work regions related to all steps of the jib assembling work by one region image request to the server S1. In this case, the server S1 generates information related to the region images for all steps of the jib assembling work. The server S1 generates one response including the information related to the region images for all steps of the jib assembling work. Then, the server S1 transmits the response to the client terminal T. The client terminal T displays, on the display unit 12, the information related to the region images for all steps of the jib assembling work, the information being presented from the server S1. According to such a method, the operator can confirm the information related to the region images for all steps of the jib assembling work only by one region image request.

In the above-described operation example, the operator determines whether to perform the jib assembling work by viewing the region image displayed on the display unit 12. Here, the determination as to whether to perform the jib assembling work may be executed by the client terminal T. In this case, the client terminal T may display the determination result on the display unit 12. Alternatively, the determination as to whether to perform the jib assembling work may be executed by the server S1. In this case, the server S1 may include the determination result in a response to be transmitted to the client terminal T.

This application is based upon and claims the benefit of priority from Japanese Patent Application No. 2023-73508, filed on April 27, 2023, the entire contents of which are incorporated herein by reference.

### Industrial Applicability

The present invention can be suitably used for building design and work planning in consideration of work of a working machine such as a crane.

### Reference Signs List

BS BIM support system
A BIM application
M Support module
M1, M2, M3, M4 Manufacturer
T Client terminal
11 Input unit
12 Display unit
13 Communication unit
14 Storage unit
141 First storage unit
142 Second storage unit
143 Third storage unit
15 Control unit
16 First control unit
17 Second control unit
171 Communication control unit
172 Support control unit
176 Region image processing unit
21 Communication unit
22 Storage unit
23 Control unit
231 Request acquisition unit
232 Calculation unit
233 Response issuing unit
31 Request
32 Server specifying information
33 Region image request
34 Parameter
36 Specification data
37 Information related to region image
38 Response
1001, 2001 Processor
1002 Input device
1003 Output device
1004, 2002 Memory
1005, 2003 Storage
1006, 2004 Communication interface
1007, 2005 Power supply circuit
1008, 2006 Bus
C Crane
C-1, C-2 mast
C-21, C-22, C-23 tension link
C-3 Boom
C-4 Jib
G1 Building image
G2 Crane image
G3, G3A, G3B Region image
G30, G31, G32Region image
G33, G34, G35Region image
S1, S2, S3, S4 Server
N Network

## Claims

1. A work information server comprising:
a request acquisition unit that acquires a request including information related to work of assembling a jib to a crane from an image application which operates in a terminal capable of displaying an image of the crane;
a storage unit that stores pieces of specification data of the crane and the jib; and
a control unit that generates information related to a region image to be used by the crane and the jib in the work based on the information related to the work that is included in the request and the pieces of specification data, and presents a response including the generated information related to the region image to the image application.

2. The work information server according to claim 1, wherein
the information related to the work includes
model information that is information related to a model of the crane,
posture information that is information related to a posture of the crane,
jib information that is information related to the jib,
work type information that is information related to a type of the work, and
work stage information that is information related to a work stage of the work, and
the control unit generates information related to the region image based on the model information, the posture information, the jib information, the work type information, the work stage information, and the pieces of specification data.

3. The work information server according to claim 1, wherein
the control unit
generates information related to a procedure of the work based on the information related to the work, and
presents the response including the information related to a procedure of the work to the image application.

4. The work information server according to claim 1, wherein
the control unit
determines whether the work can be performed based on the information related to the work, and
presents the response including a determination result to the image application.

5. An image application that operates in a terminal capable of displaying an image of a crane on a display unit,
in a case where the image application is executed by the terminal, the image application causing the terminal to:
generate a request including information related to work of assembling a jib to the crane;
transmit the request to a work information server connected to the terminal via a network;
acquire, from the work information server, a response including information related to a region image to be used by the crane and the jib in the work; and
display, on the display unit, the region image together with the image of the crane based on the information related to the region image.

6. The image application according to claim 5, wherein
in a case where the image application is executed by the terminal, the image application causes the terminal to:
transmit the request every time a posture of the crane changes, and
display, on the display unit, the region image together with the image of the crane based on the acquired information related to the region image.

7. The image application according to claim 5, wherein
in a case where the image application is executed by the terminal, the image application causes the terminal to:
transmit the request to the work information server in a state where the image of the crane is displayed on the display unit,
acquire a response including information related to the region image to be used by the crane and the jib in all steps of the work, and
display, on the display unit, the region image together with the image of the crane based on the acquired information related to the region images.

8. The image application according to claim 5, wherein
in a case where the image application is executed by the terminal, the image application causes the terminal to:
determine whether the work can be performed based on the information related to the region image and the image displayed on the display unit, and
display a determination result on the display unit.

9. An information provision method that is executed in a work information server connected to a terminal on which an image application operates, the image application being an application capable of displaying an image of a crane on a display unit, the information provision method comprising:
acquiring a request including information related to work of assembling a jib to the crane from the image application which operates in a terminal capable of displaying an image of the crane;
generating information related to a region image to be used by the crane and the jib in the work based on pieces of specification data of the crane and the jib that are stored in advance, and the information related to the work that is included in the request; and
presenting a response including the generated information related to the region image to the image application.

10. An information acquisition method that is executed in a terminal on which an image application operates, the image application being an application capable of displaying an image of a crane on a display unit, the information acquisition method comprising:
generating a request including information related to work of assembling a jib to the crane;
transmitting the request to a work information server connected to the terminal via a network;
acquiring, from the work information server, a response including information related to a region image to be used by the crane and the jib in the work; and
displaying, on the display unit, the region image together with the image of the crane based on the information related to the region image.

11. An information acquisition system comprising:
an image application that operates in a terminal capable of displaying an image of a crane on a display unit; and
a work information server that is connected to the terminal, wherein
the image application causes the terminal to:
transmit a request including information related to work of assembling a jib to the crane to the work information server connected to the terminal via a network, and
the work information server
generates information related to a region image to be used by the crane and the jib in the work based on pieces of specification data of the crane and the jib that are stored in advance and information related to the work that is included in the request acquired from the image application, and
presents a response including the generated information related to the region image to the image application.
